# FASCICULE DE BREVET EUROPEEN

(11) **EP 0 848 761 B1**
(45) Date de publication et mention de la délivrance du brevet: **16.06.1999**
(21) Numéro de dépôt: 96930225.6
(22) Date de dépôt: 06.09.1996
(51) Int. Cl.: C23C 14/48, C23C 14/28, C23C 14/04, H01S 3/0941, B23K 26/00

(54) **DISPOSITIF A MICROTETE PHOTOIONIQUE**
VORRICHTUNG MIT MINIATURISIERTEM PHOTOIONISCHEM KOPF
DEVICE COMPRISING A PHOTOIONIC MICRO-HEAD

(30) Priorité: 08.09.1995 FR 9510544
(43) Date de publication de la demande: 24.06.1998
(73) Titulaire: COMMISSARIAT A L'ENERGIE ATOMIQUE, 75015 Paris (FR)
(72) Inventeur: ELOY, Jean-François, Albert, F-33170 Gradignan (FR)
(74) Mandataire: Des Termes, Monique
(86) Numéro de dépôt international: FR9601371
(87) Numéro de publication internationale: WO9709461

(56) Documents cités:
- EP-A- 0 390 525
- WO-A-95/07368
- US-A- 3 622 743

## Description

### Domaine technique

L'invention concerne un dispositif à microtête photoionique commandé de façon automatique et permettant de traiter des surfaces de matériaux, en particulier, des circuits électroniques afin de les réparer.

L'invention trouve des applications dans les domaines de l'électronique et de la micro-électronique pour le dépôt localisé de couches spécifiques, la restauration ou l'annihilation de fonctions des composants d'un micro-circuit ou encore la réalisation de nouveaux types d'alliages pour connexions électriques.

Elle peut, en particulier, s'appliquer à la réparation de circuits ou composants électroniques localisés dans des milieux difficilement accessibles tels que les milieux hostiles ou l'espace.

### Etat de la technique

Il est connu que la composition de la surface d'un matériau peut être modifiée par un ajout de matière ou bien par une implantation ionique de certaines espèces chimiques.

Pour cela, il existe des dispositifs de traitement de matériaux à tête photoionique miniaturisée qui permettent justement de modifier la composition de la surface d'un matériau. Un exemple de dispositif de traitement de matériau à tête photoionique miniaturisée est décrit dans le document FR-A-2 709 763.

En général, les dispositifs de traitement de matériaux connus comportent une tête photoionique sur laquelle est fixée l'extrémité d'une fibre optique. A l'autre extrémité de la fibre optique, se trouve un laser de puissance apte à émettre un faisceau laser pulsé ; ce laser de puissance est associé à des moyens d'injection du faisceau laser dans la fibre optique. Généralement, la tête photoionique est en outre associée à une source de lumière pulsée.

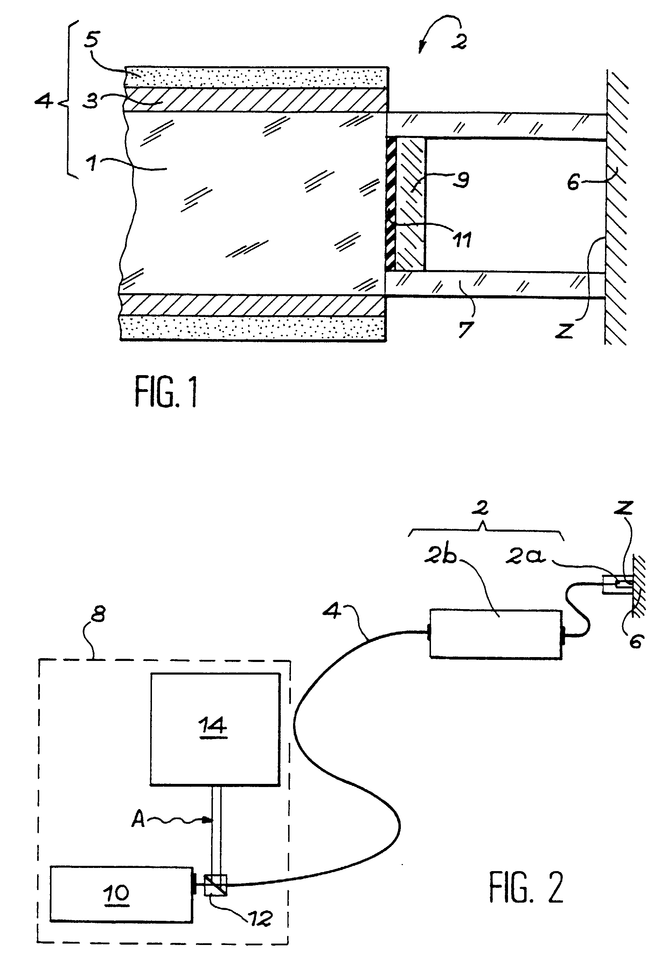

Selon les modes de réalisation les plus courants actuellement, la source de lumière pulsée et la tête photoionique sont réunies et forment un stylet à microtête photoionique. C'est ce stylet qui est représenté schématiquement sur la figure 1.

Sur la figure 1, on a donc représenté schématiquement ce stylet fixé sur une fibre optique 1 ; cette fibre optique 1 est entourée, sur toute sa longueur, d'une gaine électriquement conductrice 3 (par exemple une gaine métallique tressée) qui entoure la gaine optique de la fibre 1 sur toute la longueur de celle-ci. En outre, cette gaine conductrice 3 est elle-même entourée d'une gaine électriquement isolante 5 qui joue le rôle de gaine de protection.

La gaine conductrice 3 sert à la fois de blindage pour la fibre optique 1 et d'alimentation électrique pour assurer le bon fonctionnement de la microtête photoionique 2. La gaine isolante 5 qui entoure hermétiquement la gaine conductrice 3, permet d'éviter tout phénomène électrique ou phénomène claquage, pouvant perturber le fonctionnement de la microtête.

Par la suite, l'ensemble constitué de la fibre optique entourée des gaines conductrice 3 et isolante 5 sera appelé, guide d'ondes optiques et sera référencé 4.

A cette fibre optique 1 est donc fixée une tête photoionique 2 ; celle-ci comporte une bague de confinement 7, électriquement isolante, dont le diamètre extérieur est sensiblement égal au diamètre extérieur de la fibre optique 1. Cette bague de confinement 7 est fixée sur une première extrémité de la fibre optique 1. Par ailleurs, cette bague de confinement 7 est destinée à venir se placer contre la surface du matériau à traiter 6. Cette bague de confinement 7, métallisée sur sa face interne, entoure donc une zone Z de la surface du matériau 6 ; c'est cette zone Z qui doit être traitée.

Cette bague de confinement est destinée, d'une part, à l'application du potentiel électrique requis ou non par la mise en oeuvre de l'implantation ionique et, d'autre part, à diriger le plasma dans un espace limité et à localiser le phénomène d'interaction avec la partie localisée et sélectionnée de la zone Z de la surface du matériau à traiter, pour induire le phénomène de photoconduction.

A l'intérieur de cette bague de confinement 7 est placée une couche mince 9 réalisée dans la matière que l'on souhaite projeter sur la zone Z de la surface du matériau 6.

Dans certains modes de réalisation, la couche mince 9 est placée contre la face d'extrémité de la fibre optique 1. Lors du traitement de la zone Z, c'est cette couche mince 9 qui sera projetée, par onde de choc, sur la surface du matériau 6.

Dans d'autres modes de réalisation, à savoir celui représenté sur la figure 1, une couche intermédiaire 11 est placée entre l'extrémité de la fibre optique 1 et la couche mince 9. Cette couche intermédiaire 11 constitue une couche d'adaptation d'impédance optique qui permet de réduire le taux d'indice optique entre le matériau constitutif de la fibre optique 1 et le matériau constitutif de la couche mince 9. Cette succession de couches minces réalisées en différents matériaux assure la délivrance du flux de puissance lumineuse à l'extrémité de la tête miniature.

Le principe de fonctionnement d'une tête photoionique telle que celle qui vient d'être décrite étant expliqué dans le document FR-A-2 709 763, il ne sera pas décrit de façon plus détaillée dans la présente demande.

Par ailleurs, on sait que tous les circuits électroniques ou microélectroniques sont susceptibles de subir une panne accidentelle, souvent due au disfonctionnement de l'un des composants du circuit. Or, dans certaines applications, en particulier dans les applications réalisées dans l'espace ou dans tout autre milieu inaccessible, une panne d'un circuit peut avoir de lourdes conséquences. Aussi, pour éviter ces pannes, il est connu de dédoubler, voir même tripler, une ou plusieurs partie(s) de ces circuits électroniques. De cette façon, lorsque l'un des circuits subit une panne, le circuit secondaire (circuit de dédoublement) prend la relève.

Généralement, si une panne se présente, le ou les circuits de dédoublement concernés sont activés par des systèmes d'asservissement télécommandés par des faisceaux d'ondes électromagnétiques de fréquences prédéterminées.

Or, une telle technique basée sur le dédoublement des circuits entraîne une augmentation de l'encombrement, ainsi que du coût de fabrication.

### Exposé de l'invention

L'invention a justement pour but de remédier à cet inconvénient. A cette fin, elle propose un dispositif à microtête photoionique autocommandée permettant de réparer, à distance, un ou plusieurs composant(s) défectueux par dépôt de matériau. Ce dispositif est commandé automatiquement à partir d'une source laser qui assure une mise en oeuvre quasi-instantanée de la procédure de sauvegarde, c'est-à-dire de la procédure permettant de pallier au disfonctionnement du circuit défectueux.

De façon plus précise, l'invention concerne un dispositif de sauvegarde d'un circuit ou d'une partie de circuit électronique situé dans une zone inaccessible. Ce dispositif se caractérise par le fait qu'il comporte :
- un photoconnecteur assurant un traitement du circuit ou de la partie du circuit électronique par dépôt de matière ou implantation ionique, ce photoconnecteur comprenant :
   . une première source lumineuse apte à générer une énergie lumineuse pulsée ;
   . au moins un guide d'ondes optiques ayant une première extrémité fixée sur la première source lumineuse ;
   . au moins une seconde source lumineuse fixée sur une seconde extrémité du guide d'ondes optiques pour recevoir l'énergie lumineuse émise par la première source et la transformer en onde de choc ;
   . au moins une tête photoionique miniaturisée associée à la seconde source lumineuse pour assurer la diffusion de la lumière fournie par ladite seconde source lumineuse ; et
- un système de commande automatique apte à contrôler l'émission d'énergie lumineuse envoyée par la première source lumineuse dans le guide d'ondes optiques et comportant :
   . des moyens d'injection de l'énergie lumineuse émise par la première source lumineuse dans le guide d'ondes optiques ;
   . des moyens d'asservissement (A) fournissant des informations relatives à l'état du circuit électronique à sauvegarder ; et
   . des moyens de commande électroniques qui, en fonction de l'information fournie par des moyens d'asservissement délivrent, ou non, un signal de déclenchement des moyens d'injection.

Selon l'invention, les moyens d'injection de l'énergie lumineuse comportent un composant optoélectronique assurant, en fonction du signal de commande reçu, le passage ou le blocage de la lumière vers le guide d'ondes optiques.

Selon un mode de réalisation de l'invention, la première source lumineuse est une source continue qui émet en permanence une énergie lumineuse pulsée.

Selon un autre mode de réalisation de l'invention, la première source lumineuse est une source non-continue dont l'émission d'énergie lumineuse est déclenchée par le signal de commande, en simultanéité avec le déclenchement des moyens d'injection.

Selon une variante de l'invention, le dispositif comporte une pluralité de têtes photoioniques reliées chacune à une seconde source lumineuse, elle-même connectée au système de commande automatique par l'intermédiaire d'un guide d'ondes optiques.

### Brève description des figures

- La figure 1, déjà décrite, représente schématiquement une microtête photoionique, de type connu ; et
- La figure 2 représente schématiquement le circuit reliant la microtête photoionique de la figure 1 au système de contrôle automatique de l'émission de lumière conforme à l'invention.

### Mode de réalisation de l'invention

Sur la figure 2, on a représenté le dispositif de l'invention avec son photoconnecteur et son système de commande automatique qui permettent de pallier, par dépôt de matériau ou ionisation, à un disfonctionnement d'un circuit ou d'une partie d'un circuit électronique, cette partie de circuit électronique pouvant être simplement un composant de ce circuit.

La zone, référencée Z sur la figure 2, représente cette partie du circuit défectueux que l'on cherche à réparer au moyen d'une projection de matériau ou d'une ionisation.

Comme montré sur la figure 2, le photo-connecteur comporte une microtête photoionique miniaturisée 2 qui est reliée au système de commande automatique par l'intermédiaire d'un guide d'ondes optiques 4 constitué d'une fibre optique 1 entourée d'une gaine conductrice 3, elle-même entourée d'une gaine isolante 5, comme expliqué dans la description de la figure 1.

Cette microtête photoionique 2 peut se présenter sous la forme d'un stylet tel que celui représenté sur la figure 1. Elle peut également se présenter sous la forme d'une microtête 2a dissociée de la source lumineuse 2b ; on parlera alors de "microtête dissociée", c'est-à-dire d'une microtête qui est connectée à la source lumineuse 2b par un guide d'ondes optiques. C'est ce mode de réalisation de la microtête photoionique qui est schématisé sur la figure 2. La source lumineuse porte alors la référence 2b et la tête photoionique porte la référence 2a, l'ensemble de la microtête photoionique dissociée étant référencée 2.

La source de lumière 2b peut être une source cohérente ou, au contraire, une source non cohérente. Par exemple, elle peut être une micropuce laser ou bien une diode laser. En particulier, elle peut être une microsource laser ou bien une microsource pulsée dont le flux lumineux autodéclenché ou déclenché électriquement est d'une puissance suffisante pour permettre, suivant le mode de réalisation choisi :
- soit de volatiliser la couche mince de matériau solide 9 déposée préalablement à l'extrémité du guide d'ondes optiques 4 contre la couche intermédiaire 11 et de l'implanter ioniquement dans la zone Z de la surface de matériau 6 à transformer par implantation, c'est-à-dire sur le composant ou le circuit à réparer ;
- soit d'impacter directement la zone Z de la surface du matériau 6, c'est-à-dire le composant ou le circuit à réparer, afin d'en modifier directement ses propriétés physico-chimiques, ainsi que ses propriétés de photoconductivité.

Quel que soit le mode de réalisation choisi de la microtête photoionique 2, cette microtête 2 est reliée au système de commande automatique 8 de l'émission d'énergie lumineuse par l'intermédiaire du guide d'ondes optiques 4, déjà décrit précédemment.

Selon une variante de l'invention, non représentée sur la figure par mesure de simplification, le dispositif comporte plusieurs microtêtes photoioniques 2 reliées chacune par un guide d'ondes optiques 4 au système de commande automatique 8. Dans un tels cas, l'ensemble des microtêtes travaillent en parallèle, c'est-à-dire qu'elles effectuent les mêmes opérations en même temps sur des zones différentes du matériau 6.

Le système de commande automatique 8 de l'émission d'énergie lumineuse comporte une source d'énergie électrique pulsée 10 munie d'une unité de stockage d'énergie électrique ou électromagnétique. Cette source d'énergie 10 assure l'alimentation en énergie de la source lumineuse 2b. L'énergie électrique émise par la source 10 est un faisceau de lumière pulsée qui est transmis à la source lumineuse 2b via le guide optique 4.

Cette source d'énergie électrique pulsée 10 peut être, selon une première variante, une source d'énergie continue, c'est-à-dire une source d'énergie qui émet en permanence un faisceau de lumière pulsée ou, au contraire, une source d'énergie électrique non continue qui ne génère de l'énergie qu'à réception d'un signal de commande.

La source d'énergie électrique pulsée 10 est appelée également source-pompe, car elle permet à la source lumineuse 2b de pomper l'énergie lumineuse qui lui est nécessaire pour projeter une onde de choc destinée à permettre la modification des propriétés de surface du matériau 6. Cette source pompe 10 peut être une source de lumière cohérente, c'est-à-dire qu'elle peut être un laser de puissance ou une diode laser ou, au contraire, une source de lumière non cohérente, telle qu'un flash de rayonnement électromagnétique.

Cette source est alimentée elle-même de façon continue, grâce à une unité de stockage d'énergie qui peut être intégrée dans la source elle-même, comme représenté sur la figure 2.

Le système de commande automatique 8 comporte de plus un système optoélectronique d'injection 12, relié à la source d'énergie électrique pulsée 10 et assurant le passage ou le blocage de l'énergie électrique générée par cette source d'énergie 10 vers le guide d'ondes optiques 4. Le choix consistant à bloquer ou, au contraire, à laisser passer l'énergie électrique est fonction des signaux de commande reçus par le système optoélectronique en provenance d'un système générateur de signaux de commande 14.

Plus précisément, le système optoélectronique 12 comporte un composant optoélectronique, par exemple une cellule de Pockels®, dont les propriétés optiques, telles que l'indice de réfraction et l'indice d'extinction, sont modifiées instantanément par l'application d'un champ électrique ou d'une polarisation électrique. Ce composant optoélectronique joue ainsi le rôle d'une porte optique.

Ainsi, lorsque la source-pompe 10 est une source continue, par exemple une diode laser, le déclenchement du système opto-électronique 12, à réception de l'ordre de déclenchement émis par le système 14, assure le passage de l'énergie de la source-pompe 10 vers le guide d'ondes optiques 4, ce qui revient à dire qu'il ouvre une porte optique de façon à permettre l'injection de l'énergie électrique pulsée vers le guide d'ondes optiques 4. Pour une telle source d'énergie continue, on parle de source auto-alimentée.

Dans le cas contraire, lorsque la source d'énergie est non continue, le système opto-électronique 12, à réception de l'ordre de déclenchement, assure le déclenchement de la source d'énergie 10 ainsi que l'ouverture de la porte optique.

Plus précisément, le système opto-électronique 12 est déclenché à réception d'un signal de commande délivré par le système générateur de signaux de commande 14. Le signal émis par le système générateur 14 est donc un signal de déclenchement, appelé également "TRIGGER", qui assure le déclenchement d'une fonction de sauvegarde, c'est-à-dire l'injection d'un faisceau lumineux envoyé vers la microtête 2 afin que celle-ci projette une couche de matériau sur la partie de circuit ou le composant à traiter.

A titre indicatif, ce système générateur de signaux de commande 14 peut comporter un amplificateur différentiel à une entrée et plusieurs sorties, l'un des signaux issus de ce système générateur 14 assurant, par exemple, le déclenchement de la source-pompe 10 (lorsque la source est de type non continu) et l'autre signal issu de ce système générateur 14 assurant le déclenchement du système opto-électronique 12.

Ce système générateur 14 peut générer, par exemple, un signal optique ou bien un signal électromagnétique ou encore un signal électrique, à destination du système optoélectronique 12.

Comme on le constate sur la figure 2, le système optoélectronique 12 et le système générateur de signaux de commande 14 comportent une double connexion permettant un échange d'informations entre eux ; Ces informations sont, d'une part, l'ordre de déclenchement envoyé par le système générateur 14 au système opto-électronique 12 et, d'autre part, une information indiquant l'état du système. Ces informations prennent également en compte les informations fournies par le système d'asservissement A. Celui-ci est représenté sur la figure 2 simplement par une flèche schématisant l'ensemble des informations relatives à l'état du circuit électronique à contrôler et indiquant si un composant ou une partie du circuit est en disfonctionnement. L'information fournie par ce système d'asservissement A est prise en compte par le système générateur de signaux de commande 14 qui, en fonction de cette information, envoi ou non un ordre de déclenchement du système opto-électronique 12.

On comprend ainsi que le dispositif de l'invention fonctionne de façon autonome, ce qui signifie qu'il trouve en lui-même l'énergie et les consignes de sauvegarde nécessaires pour réparer le circuit défectueux. Un tel dispositif peut donc être embarqué.

Le dispositif de l'invention permet ainsi, à distance et sans lien physique matérial, de commuter rapidement des courants élevés, des champs électriques ou des potentiels électriques élevés et ceci avec des temps de réponses pouvant atteindre 10⁻¹² secondes (temps calculé à partir de l'instant d'arrivée de l'ordre à exécuter).

Pour plus de précision, on peut décrire le dispositif de l'invention à travers son fonctionnement qui est le suivant :
- alimentation électrique et continue de la source-pompe lumineuse 10 ;
- en régime d'attente, fermeture de la porte opto-électronique 12 ;
- émission, par le système générateur de signaux de commande 14, d'un ordre de déclenchement pour ouvrir la porte opto-électronique 12 ;
- ouverture instantanée de cette porte opto-électronique 12 et, simultanément, déclenchement de la source pompe 10, si celle-ci est une source non continue, avec injection du faisceau pompe laser dans le guide d'ondes optiques 4 ;
- pompage par la source lumineuse 2b de l'énergie fournie par la source pompe 10.

A la suite de cette succession d'opérations, peuvent intervenir deux variantes du fonctionnement :
Première variante : volatilisation par l'impulsion laser de la couche mince 9 de matériau solide déposée préalablement à l'extrémité du guide d'ondes optiques 4 ; puis implantation de l'élément chimique constituant la couche mince 9 dans le matériau cible 6 (partie de circuit ou composant) et enfin, dans le cas où un tel effet est recherché, photocommutation induite par l'impact d'une deuxième impulsion laser sur la partie de la surface du matériau modifié chimiquement.
Deuxième variante : impact direct du faisceau pompe émergeant de la microtête 2 sur le matériau 6 (partie de circuit ou composant) afin de modifier directement ses propriétés de photoconduction pouvant ainsi générer, dans le cas d'un composant électronique, une photocommutation dans un circuit aménagé spécialement et préalablement à cet effet.

Comme expliqué précédemment, ce dispositif fonctionne de manière totalement autonome puisque le signal électrique qui active le dispositif est celui résultant d'un disfonctionnement qui peut être électrique ou plasmatique. En particulier, ce dispositif de l'invention assure une procédure de sauvegarde instantanée et de protection-flash des composants électroniques, microprocesseurs, et calculateurs contre les effets de surcharge, de hautes tensions et de coups de foudre tels que, par exemple, pour les claquages d'éléments de panneaux solaires de satellite dans le plasma ionosphérique.

Il permet, en outre, le déclenchement-flash à distance de condensateurs électriques, les commutations à distance de portes électroniques de puissance, les décharges à distance de dispositifs ou d'isolants en circonstances accidentelles, la protection automatique ultra rapide de dispositifs de sécurité avec verrouillage anti-intrusion. Il permet aussi la destruction synchronisée et le verrouillage de fonctions électroniques.

## Revendications

1. Dispositif de sauvegarde d'un circuit ou d'une partie d'un circuit électronique situé dans une zone inaccessible, caractérisé en ce qu'il est activé par un signal électrique résultant d'un dysfonctionnement du circuit électronique à sauvegarder et en ce qu'il comporte :
- un photoconnecteur assurant un traitement du composant ou du circuit électronique par dépôt de matière ou implantation ionique et comprenant :
. une première source lumineuse (10) apte à générer une énergie lumineuse pulsée ;
. au moins un guide d'ondes optiques (4) ayant une première extrémité fixée sur la première source lumineuse ;
. au moins une seconde source lumineuse (2b) fixée sur une seconde extrémité du guide d'ondes optiques pour recevoir l'énergie lumineuse émise par la première source et la transformer en onde de choc ;
. au moins une tête photoionique miniaturisée (2a) associée à la seconde source lumineuse pour assurer la diffusion de la lumière fournie par ladite seconde source lumineuse ; et
- un système de commande automatique (8) apte à contrôler l'émission d'énergie lumineuse envoyée par la première source lumineuse dans le guide d'ondes optiques et comportant :
. des moyens d'injection (12) de l'énergie lumineuse émise par la première source lumineuse dans le guide d'ondes optiques ;
. des moyens d'asservissement (A) fournissant des informations relatives à l'état du circuit électronique à sauvegarder ; et
. des moyens de commande électroniques (14) qui, en fonction de l'information fournie par les moyens d'asservissement délivrent, ou non, un signal de déclenchement des moyens d'injection.

2. Dispositif selon la revendication 1, caractérisé en ce que les moyens d'injection de l'énergie lumineuse comportent un composant opto-électronique assurant, en fonction du signal de commande recu, le passage ou le blocage de la lumière vers le guide d'ondes optiques.

3. Dispositif selon l'une quelconque des revendications 1 et 2, caractérisé en ce que la première source lumineuse est une source continue qui émet en permanence de l'énergie lumineuse pulsée.

4. Dispositif selon l'une quelconque des revendications 1 et 2, caractérisé en ce que la première source lumineuse est une source non-continue dont l'émission d'énergie lumineuse est déclenchée par le signal de commande, en simultanéité avec le déclenchement des moyens d'injections.

5. Dispositif selon l'une quelconque des revendications 1 à 4, caractérisé en ce qu'il comporte une pluralité de têtes photoioniques reliées chacune à une seconde source lumineuse, elle-même connectée au système de commande automatique par l'intermédiaire d'un guide d'ondes optiques.

## Patentansprüche

1. Vorrichtung zur Reparatur bzw. Bearbeitung einer in einer unzugänglichen Zone befindlichen elektronischen Schaltung oder eines Teils einer elektronischen Schaltung,
**dadurch gekennzeichnet,**
daß sie durch ein elektrisches Signal aktiviert wird, das aus einer Betriebsstörung der zu schützenden elektronischen Schaltung resultiert, und dadurch, daß sie enthält:
- einen Photoverbinder, der eine Bearbeitung der elektronischen Komponente oder elektronischen Schaltung durch Materialabscheidung oder Ionenimplantation gewährleistet und umfaßt:
. eine erste Lichtquelle (10), fähig eine gepulste Lichtenergie zu erzeugen;
. wenigstens einen Lichtwellenleiter (4), mit einem ersten Ende an der ersten Lichtquelle befestigt;
. wenigstens eine zweite Lichtquelle (2b), befestigt an einem zweiten Ende des Lichtwellenleiters, um die von der ersten Quelle abgestrahlte Energie zu empfangen und in Stoßwellen umzuwandeln;
. wenigstens einen miniaturisierten Photoionenkopf (2a) in Verbindung mit der zweiten Lichtquelle, um die Ausbreitung des durch die genannte zweite Lichtquelle gelieferten Lichts zu gewährleisten; und
- ein automatisches Steuersystem (8), um die Lichtenergieabstrahlung der ersten Lichtquelle in den Lichtwellenleiter zu kontrollieren, umfassend:
. Einspeisungseinrichtungen (12) der von der ersten Lichtquelle abgestrahlten Energie in den Lichtwellenleiter;
. Regelungseinrichtungen (A), die Informationen bezüglich des Zustands der zu schützenden elektronischen Schaltung liefern; und
. elektronische Steuereinrichtungen (14), die in Abhängigkeit von der durch die Regelungseinrichtungen gelieferten oder nicht gelieferten Information ein Signal zum Auslösen der Einspeisungseinrichtungen liefern.

2. Vorrichtung nach Anspruch 1, dadurch gekennzeichnet, daß die Lichtenergie-Einspeisungseinrichtungen eine optoelektronische Komponente umfassen, die in Abhängigkeit von dem empfangenen Signal das Licht in Richtung Lichtwellenleiter durchlassen oder blockieren.

3. Vorrichtung nach einem der Ansprüche 1 und 2, dadurch gekennzeichnet, daß die erste Lichtquelle eine kontinuierliche Quelle ist, die permanent gepulste Lichtenergie abstrahlt.

4. Vorrichtung nach einem der Ansprüche 1 und 2, dadurch gekennzeichnet, daß die erste Lichtquelle eine nichtkontinuierliche Quelle ist, deren Lichtenergieabstrahlung durch das Steuersignal ausgelöst wird, simultan zu der Auslösung der Einspeisungseinrichtungen.

5. Vorrichtung nach einem der Ansprüche 1 bis 4, dadurch gekennzeichnet, daß sie eine Vielzahl photoionischer Köpfe umfaßt, jeder mit einer zweiten Lichtquelle verbunden, die ihrerseits über einen Lichtwellenleiter an das automatische Steuersystem angeschlossen ist.

## Claims

1. Backup apparatus for an electronic circuit or part thereof installed in a location where access is difficult, characterized in that it is activated by an electric signal resulting from a malfunction of the electronic circuit to be backed up and in that it comprises:
- a photoconnector that treats an electronic circuit or part thereof by deposition of material or ionic implantation, said photoconnector comprising:
. a first light source (10) capable of generating pulsed luminous energy,
. at least one optical wave guide (4), one end of which is attached to the first light source,
. at least one second light source (2b) attached to a second end of the optical wave guide to receive the luminous energy emitted by the first source and transform it into a shock wave,
. at least one miniaturized photoionic head (2a) associated with the second light source to diffuse the light supplied by the said second light source, and
- an automatic control system (8) for controlling emissions of the luminous energy transmitted by the first light source into the optical wave guide and comprising:
- means (12) for injecting the luminous energy emitted by the first light source into the optical wave guide,
- slaving means (A) supplying information relative to the state of the electronic circuit to be backed up, and
- electronic control means, which, as a function of the information supplied by the slaving means do or do not deliver a signal triggering injection means.

2. Apparatus according to claim 1, characterized in that the luminous energy injection means include an optoelectronic component that either transmits the light to the optical wave guide or prevents it reaching the optical wave guide depending on the control signal received.

3. Apparatus according to either of the claims 1 and 2, characterized in that the first light source is a continuous source that emits permanent pulsed luminous energy.

4. Apparatus according to either of the claims 1 and 2, characterized in that the first light source is a non-continuous source whose emission of luminous energy is triggered by the control signal at the same time as the injection means are triggered.

5. Apparatus according to any one of the claims 1 to 4, characterized in that the apparatus comprises a plurality of photoionic heads, each connected to a second light source that is itself connected to the automatic control system via an optical wave guide.
